# FASCICULE DE BREVET EUROPEEN

(11) **EP 3 182 227 B1**
(45) Date de publication et mention de la délivrance du brevet: **24.06.2020**
(21) Numéro de dépôt: 15201215.9
(22) Date de dépôt: 18.12.2015
(51) Int. Cl.: G04D 1/06

(54) **PROCEDE DE TRAITEMENT DE COMPOSANTS D'HORLOGERIE SUR BOUCLARD, ET BOUCLARD**
VERFAHREN ZUR BEHANDLUNG VON UHRKOMPONENTEN AUF EINEM GESTELL, UND ENTSPRECHENDES GESTELL
METHOD FOR TREATING CLOCK COMPONENTS ON A RACK, AND RACK

(43) Date de publication de la demande: 21.06.2017
(73) Titulaire: ETA SA Manufacture Horlogère Suisse, 2540 Grenchen (CH)
(72) Inventeur: PETERS, Jean-Bernard, 2542 Pieterlen (CH)
(74) Mandataire: Giraud, Eric

(56) Documents cités:
- DE-U- 1 941 694
- FR-A1- 2 756 768
- JP-A- S60 165 394

## Description

### Domaine de l'invention

L'invention concerne un procédé de traitement de composants d'horlogerie sur bouclard.

L'invention concerne un tel bouclard.

L'invention concerne le domaine du traitement de composants sur bouclard, notamment pour les industries de l'horlogerie.

### Arrière-plan de l'invention

Les opérations de traitements électrolytiques ou similaires, au bain, comportent de nombreuses opérations de chargement et de déchargement d'outillages appelés bouclards, qui portent, rapportés ou intégrés, des préhenseurs sur lesquels sont accrochés les composants à traiter. Ces opérations ont une durée très importante quand elles sont réalisées manuellement, et représentent .une grosse part des coûts de production. L'automatisation des lignes de traitement est entravée par des déformations fréquentes, voire des bris, des bouclards et des préhenseurs lors des opérations de traitement, notamment par des chocs, ce qui est difficilement compatible avec l'utilisation de manipulateurs desservant des positions programmées, dont le rendement est alors très faible, ce qui oblige à recourir à des opérateurs, ou à l'utilisation de moyens de reconnaissance de forme, qui est difficile du fait de ces déformations qui sont dans toutes les dimensions, et parfois avec des amplitudes telles que le champ de vision théorique doit être agrandi pour les prendre en compte. La remise en forme manuelle périodique des préhenseurs reste néanmoins nécessaire, et les coûts correspondants continuent à grever l'exploitation.

Le document DE1941694 au nom de GREINER Electronic AG décrit un bouclard pour pièces de mouvements d'horlogerie, avec des organes porteurs en fil à ressort comportant des ondulations pour éloigner les composants portés par le bouclard, chaque fil à ressort étant combiné avec une pièce de retenue pouvant coiffer, notamment élastiquement, l'extrémité libre du fil à ressort après enfilage du ou des composants d'horlogerie.

Le document JP S60 165394A au nom de ORIENT WATCH CO Ltd décrit un outillage de maintien pour fixer des objets pour une opération de traitement de surface, cet outillage comportant des éléments en alliage de mémoire de forme et en matériau conducteur. Cet outillage doit d'abord être refroidi avec un mélange d'acétone et de glace sèche à -20°C environ de façon à obtenir une déformation pour le chargement des objets à traiter, avant de revenir à la température ambiante où les objets à traiter sont maintenus dans ces éléments en alliage à mémoire de forme qui ont alors une forme différente. Plus particulièrement, la partie de l'outillage qui est en alliage à mémoire de forme est enduite d'un isolant.

### Résumé de l'invention

L'invention se propose de réduire le coût des traitements de composants horlogers, en particulier en s'affranchissement de la déformation des préhenseurs qui est très préjudiciable à une bonne exploitation.

A cet effet, l'invention concerne un procédé de traitement de composants d'horlogerie sur bouclard, selon la revendication 1.

L'invention concerne encore un tel bouclard selon la revendication 11.

### Description sommaire des dessins

D'autres caractéristiques et avantages de l'invention apparaîtront à la lecture de la description détaillée qui va suivre, en référence aux dessins annexés, où :
- la figure 1 représente, de façon schématisée, et en perspective, un bouclard comportant une pluralité de préhenseurs ;
- la figure 2 représente, de façon similaire à la figure 1, un détail d'un préhenseur en forme de crochet, en pointillé dans sa forme de référence, et en traits interrompus et mixte deux exemples de déformées dans l'espace ;
- la figure 3 représente, de façon similaire à la figure 3, un détail d'un préhenseur en forme de crochet, avec un deuxième brin formant mousqueton en position fermée autour d'un composant ;
- la figure 4 représente, de façon similaire à la figure 2, un crochet représenté en trait pointillé dans une première forme à sa température de préparation, et en trait plein, muni d'un composant et dans une deuxième forme qu'occupe ce crochet à une température de traitement ;
- la figure 5 représente, de façon similaire à la figure 2, un crochet en position refermée autour d'un composant et dont la fermeture est au niveau d'une armature du bouclard constitue un moyen de fermeture ;
- la figure 6 montre un préhenseur en crochet comportant une partie faisant ressort pour sa fixation sur un support d'un bouclard.

### Description détaillée des modes de réalisation préférés

L'invention concerne un procédé de traitement de composants 10 d'horlogerie sur bouclard 1. Un bouclard est une structure, généralement un cadre, ou un assemblage de cadres, de forme adaptée à la fois aux moyens de traitement et aux composants à traiter, chaque cadre portant une pluralité de préhenseurs 2, de type crochet ou similaire, destinés à recevoir ces composants 10. Les préhenseurs 2 peuvent être, selon le cas, monobloc avec la structure du bouclard 1, ou être amovibles, ce qui facilite alors leur remise en géométrie ou leur remplacement.

L'invention utilise les propriétés des alliages à mémoire de forme, qu'on peut utiliser de deux façons :
- pour s'affranchir des déformations accidentelles, notamment lors du traitement, on utilise alors la propriété appelée « mémoire simple sens » en portant l'objet à une température suffisamment haute, au moins au-dessus de la température de fin de transformation martensitique Mf de l'alliage, et avantageusement au-dessus de la température de fin de transformation austénitique Af de l'alliage, à laquelle l'effet mémoire est total;
- pour utiliser l'effet dit « mémoire double sens », selon lequel un objet prend une première structure microscopique sous la température de fin de transformation martensitique Tf, et une deuxième structure microscopique au-dessus, cette transformation étant réversible et se faisant de façon instantanée.

Le but principal de l'invention est de gagner du temps de cycle sur les opérations de traitement, et, à cette fin, de s'affranchir des pertes de temps en localisation, et redressage de préhenseurs déformés lors d'un traitement, notamment par des chocs. L'intervention est surtout nécessaire au début d'un cycle de production, quand un bouclard 1 est prêt à être garni de composants 10 à traiter.

Ce procédé comporte les étapes successives consistant à :
- équiper le bouclard 1 d'une pluralité de préhenseurs 2, tous réalisés dans un même alliage à mémoire de forme, et agencés chacun pour reprendre une forme de référence avec un effet mémoire par chauffage au-dessus d'une température de fin de transformation martensitique Tf propre à cet alliage à mémoire de forme;
- porter le bouclard 1 équipé des préhenseurs 2 à une température supérieure à la température de fin de transformation martensitique Tf;
- après retour de tous les préhenseurs dans leur forme de référence, porter le bouclard 1 équipé des préhenseurs 2 à une température de préparation TP ;
- équiper le bouclard 1, au niveau d'un poste de chargement à la température de préparation TP, d'un lot de composants 10 à traiter;
- effectuer le traitement sur le bouclard 1 équipé du lot ;
- décharger le bouclard 1 des composants 10 traités.

Une opération optionnelle consiste à effectuer une autre recherche de la forme de référence des préhenseurs, à la fin d'un cycle de traitement, avant le déchargement des composants 10 traités du bouclard 1. Toutefois, l'encombrement des composants 10 traités est généralement suffisant pour permettre la localisation par les moyens de manipulation, même si les préhenseurs sont déformés. Dans le cas de la conduite de cette opération optionnelle, les opérations complémentaires consistent à :
- ramener, après l'achèvement du traitement, le bouclard 1 équipé du lot à une température supérieure à la température de fin de transformation martensitique Tf;
- puis ramener le bouclard 1 équipé du lot à la température de préparation TP, avant d'effectuer le déchargement des composants.

Plus particulièrement, lors d'une manœuvre périodique, mais non nécessairement à chaque cycle, le procédé comporte les étapes suivantes :
- équiper le bouclard 1 d'une pluralité de préhenseurs 2, tous réalisés dans un même alliage à mémoire de forme, et agencés chacun pour reprendre une forme de référence avec un effet mémoire simple sens par chauffage au-dessus d'une température de fin de transformation austénitique Af propre à cet alliage à mémoire de forme, cette température Af étant la température au-dessus de laquelle on a porté ce préhenseur après son façonnage initial, lui donnant cette forme de référence, qu'il retrouve chaque fois qu'il franchit cette température.
- porter le bouclard 1 équipé des préhenseurs 2 à une température supérieure à la température de fin de transformation austénitique Af;
- après retour de tous les préhenseurs dans leur forme de référence, porter le bouclard 1 équipé des préhenseurs 2 à une température de préparation TP ;
- équiper le bouclard 1, au niveau d'un poste de chargement à la température de préparation TP, d'un lot de composants 10 à traiter;
- effectuer le traitement sur le bouclard 1 équipé du lot ;
- décharger le bouclard 1 des composants 10 traités.

De la même façon que précédemment, on peut effectuer une recherche de la forme de référence des préhenseurs en fin de cycle, avec les opérations consistant à :
- ramener, après l'achèvement du traitement, le bouclard 1 équipé du lot à une température supérieure à la température de fin de transformation austénitique Af;
- puis ramener le bouclard 1 équipé du lot à la température de préparation TP, avant d'effectuer le déchargement des composants.

Dans une mise en œuvre particulière de l'invention, le bouclard 1 est équipé de préhenseurs 2 qui comportent chacun un premier brin 3 avec au moins une extrémité distale 4 agencée pour l'enfilage d'un composant 10. Ces préhenseurs 2 peuvent notamment prendre la forme d'un crochet, ou similaire.

Ainsi on exploite la faculté d'un composant en alliage à mémoire de forme à retrouver sa forme de référence au-dessus de la température de fin de transformation austénitique Af, même si ce préhenseur a été déformé pendant le traitement précédent, ou lors de sa manipulation en dehors de la chaîne de traitement. Son extrémité distale 4, qui a pu prendre n'importe quelle position dans l'espace, retrouve ainsi sa position théorique, et un manipulateur programmé peut la retrouver sans problème particulier. Le gain de temps très important qui en découle est un avantage majeur de l'invention, l'autre avantage important consistant à éviter des opérations de redressage manuel des préhenseurs après traitement, usuellement effectuées par les opérateurs de conduite de lignes de traitement.

Dans le cas de composants 10 de très petite taille, ou encore d'une précision particulière, ou encore nécessitant une orientation particulière sur le préhenseur 2, on peut avantageusement utiliser des moyens de détermination de position, tels que caméras ou similaires, en complément, lors de l'équipement du bouclard 1 avec le lot de composants 10 à traiter, ou de son déchargement en fin de cycle, pour identifier et vérifier la position de chaque extrémité distale 4 de chaque préhenseur 2 pour guider vers elle un tel composant 10, chargé notamment par un moyen de manipulation. Mais on comprend que la remise en forme de référence peut, dans bien des cas, permettre de s'affranchir de la présence de ces moyens de détermination de position, ce qui allège le coût d'équipement des lignes de production.

Selon l'invention, dans une variante, le premier brin 3 du préhenseur 2 est ouvert à la température de préparation TP, et est agencé pour être refermé sur lui-même en boucle se refermant autour d'un composant 10, lors d'une déformation mécanique macroscopique imprimée par un utilisateur ou un moyen de manipulation. Dans une première alternative, la forme de référence est la forme fermée, et on imprimer volontairement, par exemple par une déformation mécanique sous l'action d'un robot manipulateur, une ouverture du préhenseur à la température de préparation, pour effectuer son équipement avec un composant 10, le refermement autour du composant 10 étant alors effectué, ou bien par une autre action mécanique de déformation, ou bien par une montée suffisante en température pour retrouver la forme de référence, selon les caractéristiques du traitement appliqué. De préférence on utilise l'alternative inverse, où la forme de référence est la forme ouverte, dans laquelle le préhenseur 2 est présenté au poste de préparation, et où le refermement autour du composant 10 est effectué, ou bien par une action mécanique de déformation, ou bien par une montée suffisante en température pour retrouver la forme de référence.

Selon l'invention, dans une autre variante, le bouclard 1 est équipé de préhenseurs 2 qui comportent, face à leur extrémité distale 4, un deuxième brin 5 agencé pour former avec le premier brin 3 une boucle qui peut être refermée autour d'un composant 1, à la façon d'un mousqueton, avec le même genre de déformation mécanique que précédemment. Avantageusement, au moins un tel deuxième brin 5, et de préférence chaque deuxième brin 5, est réalisé dans le même alliage à mémoire de forme que les préhenseurs 2.

Selon l'invention, dans une autre variante encore, le bouclard 1 est équipé d'au moins un moyen de fermeture 6 faisant face à au moins une extrémité distale 4, et agencé pour former avec au moins un premier brin 3 une boucle qui peut être refermée autour d'un composant 1, à la façon d'un mousqueton, avec le même genre de déformation mécanique que précédemment. Par exemple, quand les préhenseurs 2 sont en forme de crochets répartis à la périphérie d'un cercle, le moyen de fermeture 6 peut consister en un anneau enfermant d'un seul coup la totalité des composants 10 enfilés sur les préhenseurs 2. Avantageusement, au moins un tel moyen de fermeture 6, et de préférence chaque moyen de fermeture 6, est réalisé dans le même alliage à mémoire de forme que les préhenseurs 2.

Un tel maintien enfermé des composants 10 peut être très utile en cas de composants tendant, du fait de leur densité, à flotter à la surface des bains de traitement, tels que des composants en matière plastique, ou en mousse, ou simplement pour sécuriser le bon maintien de composants coûteux,

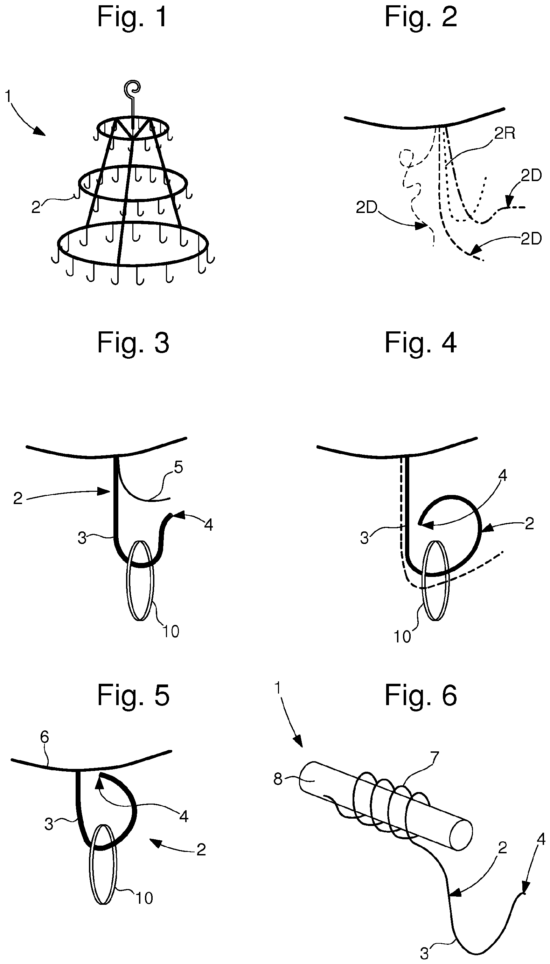

Dans une autre variante avantageuse, les préhenseurs 2 sont amovibles, pour faciliter leur reconditionnement par remise sous leur forme de référence, ou leur remplacement en cas de bris ou d'usure. De façon particulière, les préhenseurs comportent au moins une partie 7 faisant ressort, agencée pour coopérer par maintien élastique sur un support 8 du bouclard 1 ou pour maintenir le préhenseur par un autre moyen, tel que vis, bride, ou similaire. La figure 6 illustre une telle réalisation avec un préhenseur 2 en forme de crochet prolongé par un ressort spiral à boudin enfilé à force sur une tige 8 constituant le support du bouclard 1.

Le traitement concerné peut consister en un traitement électrolytique ou galvanoplastique ou d'électroformage ou de type dépôt en phase vapeur PVD, ou similaire, et chaque préhenseur 2 est alors un conducteur électrique relié électriquement au bouclard 1.

Avantageusement, l'équipement et le déchargement du bouclard 1 sont effectués par un manipulateur automatisé à la température de préparation TP.

Le traitement est de préférence effectué à une température de traitement TT, qui est supérieure à la valeur de Mf, et notamment de l'ordre de 90°C pour un alliage à mémoire de forme nickel-titane.

La température de préparation TP peut prendre différentes valeurs: elle pourrait, pour mémoire, être supérieure ou égale à la température de fin de transformation martensitique Mf. Plus particulièrement la température de préparation TP pourrait encore être supérieure ou égale à la température de fin de transformation austénitique Af, c'est-à-dire qu'on effectuerait le chargement ou le déchargement à la température à laquelle on a porté l'ensemble pour lui faire retrouver sa forme de référence, mais cette température est de l'ordre de 400°C à 550°C pour un alliage à mémoire de forme de type nickel-titane, ce qui est très élevé et peu industriel, en raison des coûts thermiques, et est susceptible d'endommager la couche isolante recouvrant usuellement tout ou partie de la structure du bouclard, de façon à éviter tout dépôt galvanique sur cette structure.

De façon plus usuelle, la température de préparation TP est une température ambiante inférieure à la température de fin de transformation martensitique Mf, ce qui facilite la manutention, mais induit une durée de redescente en température. On comprend que la mise en œuvre du procédé n'impose pas nécessairement une montée en température au-dessus de la température de fin de transformation austénitique Af, à chaque cycle, en raison du coût de chauffage, et du temps de montée en température, et de redescente à la température de préparation. L'expérience permet de déterminer une fréquence acceptable, par exemple de l'ordre de une fois par équipe, ou par jour, ou par semaine, ou tous les n lots, ou similaire. L'invention permet, aussi, la remise en forme de référence des préhenseurs en dehors du cycle de production, soit au niveau du bouclard équipé, soit au niveau des préhenseurs seuls, par exemple en vrac ce qui est plus avantageux en ce qui concerne le coût de la montée en température, dans une opération qui peut être faite en temps masqué.

Ce procédé est mis en œuvre pour le traitement de composants d'horlogerie.

L'invention concerne encore un bouclard 1 tel que conçu spécifiquement et décrit ci-dessus pour la mise en œuvre du procédé.

## Revendications

1. Procédé de traitement de composants d'horlogerie (10) sur bouclard (1), **caractérisé en ce qu'**il comporte les étapes successives consistant à :
- équiper ledit bouclard (1) d'une pluralité de préhenseurs (2) tous réalisés dans un même alliage à mémoire de forme, et agencés chacun pour reprendre une forme de référence par chauffage au-dessus d'une température de fin de transformation martensitique (Mf) propre audit alliage à mémoire de forme, les dits préhenseurs (2) comportant chacun un premier brin (3) avec au moins une extrémité distale (4) agencée pour l'enfilage d'un dit composant (10) ;
- et :
- ou bien au moins un dit préhenseur (2) comportant un dit premier brin (3) qui est ouvert à ladite température de préparation (TP), et est agencé pour être refermé sur lui-même en boucle se refermant autour d'un dit composant (10), lors d'une déformation mécanique qui lui est appliquée, ou/et comportant, face à sa dite extrémité distale (4), un deuxième brin (5) agencé pour former avec ledit premier brin (3) une boucle se refermant autour d'un dit composant (10), lors d'une déformation mécanique qui lui est appliquée,
- ou bien ledit bouclard (1) étant équipé d'au moins un moyen de fermeture (6) faisant face à au moins une dite extrémité distale (4), et agencé pour former avec au moins un dit premier brin (3) une boucle fermée quand ledit traitement est effectué sur ledit bouclard (1) équipé dudit lot ;
- porter ledit bouclard (1) équipé desdits préhenseurs (2) à une température supérieure à ladite température de fin de transformation martensitique (Mf)
- après retour de tous lesdits préhenseurs dans leur dite forme de référence, porter ledit bouclard (1) équipé desdits préhenseurs (2) à une température de préparation (TP) qui est la température ambiante, qui est inférieure à ladite température de fin de transformation martensitique (Mf) ;
- équiper ledit bouclard (1), au niveau d'un poste de chargement à ladite température de préparation (TP), d'un lot de dits composants (10) à traiter;
- effectuer ledit traitement sur ledit bouclard (1) équipé dudit lot ;
- décharger ledit bouclard (1) desdits composants (10) traités,
et **caractérisé en ce que** l'équipement et le déchargement dudit bouclard (1) sont effectués par un manipulateur automatisé à ladite température de préparation (TP), qui est une température ambiante inférieure à ladite température de fin de transformation martensitique (Mf).

2. Procédé selon la revendication 1, **caractérisé en ce qu'**il comporte les étapes successives consistant à :
- équiper ledit bouclard (1) d'une pluralité de préhenseurs (2) tous réalisés dans un même alliage à mémoire de forme, et agencés chacun pour reprendre une forme de référence par chauffage au-dessus d'une température de fin de transformation austénitique (Af) propre audit alliage à mémoire de forme, qui est supérieure à ladite température de fin de transformation martensitique (Mf);
- porter ledit bouclard (1) équipé desdits préhenseurs (2) à une température supérieure à ladite température de fin de transformation austénitique (Af);
- après retour de tous lesdits préhenseurs dans leur dite forme de référence, porter ledit bouclard (1) équipé desdits préhenseurs (2) à ladite température de préparation (TP) ;
- équiper ledit bouclard (1), au niveau d'un poste de chargement à ladite température de préparation (TP), d'un lot de dits composants (10) à traiter;
- effectuer ledit traitement sur ledit bouclard (1) équipé dudit lot ;
- ramener, après l'achèvement dudit traitement, ledit bouclard (1) équipé dudit lot à une température supérieure à ladite température de fin de transformation austénitique (Af);
- puis ramener ledit bouclard (1) équipé dudit lot à ladite température de préparation (TP);
- décharger ledit bouclard (1) desdits composants (10) traités.

3. Procédé selon la revendication 1 ou 2, **caractérisé en ce qu'**il comporte encore les étapes consistant à :
- ramener, après l'achèvement dudit traitement, ledit bouclard (1) équipé dudit lot à une température supérieure à ladite température de fin de transformation martensitique (Mf);
- puis ramener ledit bouclard (1) équipé dudit lot à ladite température de préparation (TP).

4. Procédé selon l'une des revendications 1 à 3, **caractérisé en ce que**, lors de l'équipement dudit bouclard (1) avec ledit lot de dits composants (10) à traiter, des moyens de détermination de position sont agencés pour identifier la position de chaque dite extrémité distale (4) de chaque dit préhenseur (2) pour guider vers elle un dit composant (10) chargé par un moyen de manipulation.

5. Procédé selon la revendication 4, **caractérisé en ce que** au moins un dit préhenseur (2) comporte un dit premier brin (3) qui est ouvert à ladite température de préparation (TP), et est agencé pour être refermé sur lui-même en boucle se refermant autour d'un dit composant (10), lors d'une déformation mécanique qui lui est appliquée, ou/et au moins un dit préhenseur (2) comporte, face à sa dite extrémité distale (4), un deuxième brin (5) agencé pour former avec ledit premier brin (3) une boucle se refermant autour d'un dit composant (10), lors d'une déformation mécanique qui lui est appliquée.

6. Procédé selon la revendication 4 ou 5, **caractérisé en ce que** ledit bouclard (1) est équipé d'au moins un moyen de fermeture (6) faisant face à au moins une dite extrémité distale (4), et agencé pour former avec au moins un dit premier brin (3) une boucle fermée quand ledit traitement est effectué sur ledit bouclard (1) équipé dudit lot.

7. Procédé selon la revendication 6, **caractérisé en ce que** au moins un dit moyen de fermeture (6) est réalisé dans le même alliage à mémoire de forme que lesdits préhenseurs (2).

8. Procédé selon l'une des revendications 1 à 7, **caractérisé en ce que** ledit traitement est un traitement électrolytique ou galvanoplastique ou d'électroformage ou de type dépôt en phase vapeur, et **en ce que** chaque dit préhenseur (2) est un conducteur électrique relié électriquement audit bouclard (1).

9. Procédé selon l'une des revendications 1 à 8, **caractérisé en ce que** ledit traitement est effectué à une température de traitement (TT), qui est supérieure à la valeur de la température de fin de transformation martensitique (Mf) propre audit alliage à mémoire de forme, mais inférieure à ladite température de fin de transformation austénitique (Af).

10. Procédé selon l'une des revendications 1 à 9, **caractérisé en ce que** ledit procédé est mis en œuvre pour le traitement de composants d'horlogerie ou de bijouterie ou de joaillerie.

11. Bouclard (1) pour le traitement de composants (10) d'horlogerie, ledit bouclard (1) comportant une pluralité de préhenseurs (2) adaptés à la géométrie et au traitement desdits composants (10), **caractérisé en ce que** chaque dit préhenseur (2) est réalisé dans un même alliage à mémoire de forme, et agencé pour reprendre une forme de référence par chauffage au-dessus d'une température de fin de transformation martensitique (Mf) propre audit alliage à mémoire de forme, et **en ce que** chaque dit préhenseur (2) comporte un premier brin (3) avec au moins une extrémité distale (4) agencée pour l'enfilage d'un dit composant (10), et **en ce que**, ou bien ledit premier brin (3) d'au moins un dit préhenseur (2) est en position ouverte à une température de préparation (TP) et est agencé pour être refermé sur lui-même en boucle se refermant autour d'un dit composant (10) lors d'une déformation mécanique qui lui est appliquée, ou bien au moins un dit préhenseur (2) comporte, face à ladite extrémité distale (4), un deuxième brin (5) agencé pour former avec ledit premier brin (3) une boucle se refermant autour d'un dit composant (10), lors d'une déformation mécanique qui lui est appliquée, ou bien ledit bouclard (1) comporte au moins un moyen de fermeture (6) faisant face à au moins une dite extrémité distale (4) et qui est agencé pour former avec au moins un dit premier brin (3) une boucle fermée, ledit au moins un dit moyen de fermeture (6) étant dans le même alliage à mémoire de forme que lesdits préhenseurs (2), et **caractérisé en ce qu'**au moins un dit préhenseur (2) est amovible, et **en ce que** au moins un dit préhenseur (2) comporte au moins une partie (7) faisant ressort, agencée pour coopérer par maintien élastique sur un support (8) que comporte ledit bouclard (1).

## Patentansprüche

1. Verfahren zum Bearbeiten von Uhrenkomponenten (10) an einem Gestell (1), **dadurch gekennzeichnet, dass** es die folgenden aufeinanderfolgenden Schritte umfasst:
- Ausstatten des Gestells (1) mit einer Mehrzahl Greifern (2), die alle aus derselben Legierung mit Formgedächtnis hergestellt sind und jeweils so beschaffen sind, dass sie durch Erwärmen oberhalb einer Temperatur des Ende eines martensitischen Übergangs (Mf), die für die Legierung mit Formgedächtnis charakteristisch ist, wieder eine Referenzform annehmen, wobei die Greifer (2) jeweils einen ersten Strang (3) mit mindestens einem distalen Ende (4) aufweisen, das zum Auffädeln einer Komponente (10) vorgesehen ist;
und wobei,
entweder mindestens ein Greifer (2) einen ersten Strang (3) aufweist, der bei der Vorbereitungstemperatur (TP) offen ist und so beschaffen ist, dass er bei einer mechanischen Verformung, die auf ihn ausgeübt wird, schleifenförmig auf sich selbst geschlossen wird und sich dabei um eine Komponente (10) schließt, und/oder gegenüber seinem distalen Ende (4) einen zweiten Strang (5) aufweist, der dazu vorgesehen ist, bei einer mechanischen Verformung, die auf ihn ausgeübt wird, mit dem ersten Strang (3) eine Schleife zu bilden, die sich um eine Komponente (10) schließt,
oder das Gestell (1) mit mindestens einem Schließmittel (6) ausgestattet ist, das sich gegenüber mindestens einem distalen Ende (4) befindet und dazu vorgesehen ist, mit dem mindestens einen Strang (3) eine geschlossene Schleife zu bilden, wenn an dem mit dem Satz ausgestatteten Gestell (1) die Bearbeitung durchgeführt wird;
- Bringen des mit den Greifern (2) ausgestatteten Gestells (1) auf eine Temperatur, die höher ist als die Temperatur des Ende des martensitischen Übergangs (Mf),
- nach der Rückkehr sämtlicher Greifer in ihre Referenzform Bringen des mit den Greifern (2) ausgestatteten Gestells (1) auf eine Vorbereitungstemperatur (TP), die die Umgebungstemperatur ist und die niedriger ist als die Temperatur des Ende des martensitischen Übergangs (Mf);
- Ausstatten des Gestells (1) an einer Beschickungsstation auf der Vorbereitungstemperatur (TP) mit einem Satz von zu bearbeitenden Komponenten (10);
- Durchführen der Bearbeitung an dem mit dem Satz ausgestatteten Gestell (1);
- Entnehmen der bearbeiteten Komponenten (10) von dem Gestell (1),
**dadurch gekennzeichnet, dass** das Ausstatten und das Entnehmen vom Gestell (1) durch einen automatisierten Betätiger auf der Vorbereitungstemperatur (TP), die eine Umgebungstemperatur unterhalb der Temperatur des Ende des martensitischen Übergangs (Mf) ist, durchgeführt werden.

2. Verfahren nach Anspruch 1, **dadurch gekennzeichnet, dass** es die folgenden aufeinanderfolgenden Schritte umfasst:
- Ausstatten des Gestells (1) mit mehreren Greifern (2), die alle aus derselben Legierung mit Formgedächtnis hergestellt sind und jeweils so beschaffen sind, dass sie durch Erwärmen oberhalb einer Temperatur des Ende des Austenitübergangs (Af), die für die Legierung mit Formgedächtnis charakteristisch ist und die höher ist als die Temperatur des Ende des martensitischen Übergangs (Mf), wieder eine Referenzform annehmen;
- Bringen des mit den Greifern (2) ausgestatteten Gestells (1) auf eine Temperatur, die höher ist als die Temperatur des Ende des Austenitübergangs (Af);
- nach der Rückkehr sämtlicher Greifer in ihre Referenzform Bringen des mit den Greifern (2) ausgestatteten Gestells (1) auf die Vorbereitungstemperatur (TP);
- Ausstatten des Gestells (1) an einer Beschickungsstation auf der Vorbereitungstemperatur (TP) mit einem Satz von zu bearbeitenden Komponenten (10);
- Durchführen der Bearbeitung an dem mit dem Satz ausgestatteten Gestell (1);
- nach dem Beenden der Bearbeitung Zurückführen des mit dem Satz ausgestatteten Gestells (1) auf eine Temperatur, die höher ist als die Temperatur des Ende des Austenitübergangs (Af);
- dann Zurückführen des mit dem Satz ausgestatteten Gestells (1) auf die Vorbereitungstemperatur (TP);
- Entnehmen der bearbeiteten Komponenten (10) von dem Gestell (1).

3. Verfahren nach Anspruch 1 oder 2, **dadurch gekennzeichnet, dass** es ferner die folgenden Schritte umfasst:
- nach dem Beenden der Bearbeitung Zurückführen des mit dem Satz ausgestatteten Gestells (1) auf eine Temperatur, die höher ist als die Temperatur des Ende des martensitischen Übergangs (Mf);
- dann Zurückführen des mit dem Satz ausgestatteten Gestells (1) auf die Vorbereitungstemperatur (TP).

4. Verfahren nach einem der Ansprüche 1 bis 3, **dadurch gekennzeichnet, dass** während des Beschickens des Gestells (1) mit dem Satz von zu bearbeitenden Komponenten (10) Positionsbestimmungsmittel dazu vorgesehen sind, die Position jedes distalen Endes (4) jedes Greifers (2) zu identifizieren, um ihm eine mit einem Handhabungsmittel bestückte Komponente (10) zuzuführen.

5. Verfahren nach Anspruch 4, **dadurch gekennzeichnet, dass** mindestens ein Greifer (2) einen ersten Strang (3) umfasst, der bei der Vorbereitungstemperatur (TP) offen ist und so beschaffen ist, dass er sich bei einer mechanischen Verformung, der er ausgesetzt wird, in Form einer Schleife, die eine Komponente (10) umschließt, auf sich selbst zu schließen, und/oder mindestens ein Greifer (2) gegenüber seinem distalen Ende (4) einen zweiten Strang (5) umfasst, der so beschaffen ist, dass er bei einer mechanischen Verformung, der er ausgesetzt wird, mit dem ersten Strang (3) eine Schleife bildet, die sich um eine Komponente (10) schließt.

6. Verfahren nach Anspruch 4 oder 5, **dadurch gekennzeichnet, dass** das Gestell (1) mit mindestens einem Schließmittel (6) ausgestattet ist, das sich gegenüber mindestens einem distalen Ende (4) befindet und dazu vorgesehen ist, mit mindestens einem ersten Strang (3) eine geschlossene Schleife zu bilden, wenn die Bearbeitung an dem mit dem Satz ausgestatteten Gestell (1) durchgeführt wird.

7. Verfahren nach Anspruch 6, **dadurch gekennzeichnet, dass** mindestens ein Schließmittel (6) aus derselben Legierung mit Formgedächtnis wie die Greifer (2) hergestellt ist.

8. Verfahren nach einem der Ansprüche 1 bis 7, **dadurch gekennzeichnet, dass** die Bearbeitung eine elektrolytische oder galvanoplastische Bearbeitung oder eine Elektroformungsbearbeitung oder eine Bearbeitung vom Typ Dampfphasenabscheidung ist und dass jeder Greifer (2) ein elektrischer Leiter ist, der mit dem Gestell (1) elektrisch verbunden ist.

9. Verfahren nach einem der Ansprüche 1 bis 8, **dadurch gekennzeichnet, dass** die Bearbeitung bei einer Bearbeitungstemperatur (TT) durchgeführt wird, die höher als der Wert der Temperatur des Ende des martensitischen Übergangs (Mf), die für die Legierung mit Formgedächtnis charakteristisch ist, jedoch niedriger als die Temperatur des Ende des Austenitübergangs (Af) ist.

10. Verfahren nach einem der Ansprüche 1 bis 9, **dadurch gekennzeichnet, dass** das Verfahren für die Bearbeitung von Uhren-, Schmuck- oder Juwelierkomponenten eingesetzt wird.

11. Gestell (1) zum Bearbeiten von Uhrenkomponenten (10), wobei das Gestell (1) mehrere Greifer (2) aufweist, die an die Geometrie und an die Bearbeitung der Komponenten (10) angepasst sind, **dadurch gekennzeichnet, dass** jeder Greifer (2) aus derselben Legierung mit Formgedächtnis hergestellt ist und so beschaffen ist, dass er durch Erwärmen oberhalb einer Temperatur des Ende eines martensitischen Übergangs (Mf), die für die Legierung mit Formgedächtnis charakteristisch ist, wieder eine Referenzform annimmt, und dass jeder Greifer (2) einen ersten Strang (3) mit mindestens einem distalen Ende (4) umfasst, das zum Auffädeln einer Komponente (10) vorgesehen ist, und dass entweder der erste Strang (3) mindestens eines Greifers (2) bei einer Vorbereitungstemperatur (TP) in einer offenen Position ist und dazu vorgesehen ist, sich bei einer mechanischen Verformung, die auf ihn ausgeübt wird, in Form einer Schleife, die sich um eine Komponente (10) schließt, auf sich selbst zu schließen, oder mindestens ein Greifer (2) gegenüber dem distalen Ende (4) einen zweiten Strang (5) umfasst, der dazu vorgesehen ist, bei einer mechanischen Verformung, die auf ihn ausgeübt wird, mit dem ersten Strang (3) eine Schleife zu bilden, die sich um eine Komponente (10) schließt, oder das Gestell (1) mindestens ein Schließmittel (6) umfasst, das sich gegenüber mindestens einem distalen Ende (4) befindet und dazu vorgesehen ist, mit mindestens einem ersten Strang (3) eine geschlossene Schleife zu bilden, wobei das mindestens eine Schließmittel (6) aus derselben Legierung mit Formgedächtnis wie die Greifer (2) hergestellt ist, und **dadurch gekennzeichnet, dass** mindestens ein Greifer (2) abnehmbar ist und dass mindestens ein Greifer (2) mindestens einen Teil (7) aufweist, der als Feder dient und dazu vorgesehen ist, durch elastischen Halt an einem Träger (8), den das Gestell (1) aufweist, zusammenzuwirken.

## Claims

1. Method for treatment of timepiece components (10) on a rack (1) **characterized in that** the method includes the successive steps consisting of:
- equipping said rack (1) with a plurality of grippers (2), all made of the same shape memory alloy, and each arranged to return to a reference shape through heating above a temperature of end of a martensitic transformation (Mf) specific to said shape memory alloy, said grippers (2) each comprising a first strand (3) with at least one distal end (4) arranged for the attachment of a said component (10);
- and:
- either at least one said gripper (2) comprising a said first strand (3) which is open at said preparation temperature (TP), and is arranged to be closed on itself in a loop closing around a said component (10), during a mechanical deformation that is applied thereto, and/or comprising, opposite said distal end (4) thereof, a second strand (5) arranged to form with said first strand (3) a loop closing around a said component (10) during a mechanical deformation that is applied thereto,
- or said rack (1) being equipped with at least one means of closure (6) facing at least one said distal end (4) and arranged to form with at least a said first strand (3) a closed loop when said treatment is performed on said rack (1) loaded with said batch;
- bringing said rack (1) equipped with said grippers (2) to a temperature higher than said temperature of end of a martensitic transformation (Mf);
- once all said grippers have returned to their said reference shape, bringing said rack (1) equipped with said grippers (2) to a preparation temperature (TP), which is the ambient temperature, which is lower than said temperature of end of a martensitic transformation (Mf);
- loading said rack (1), at a loading station at said preparation temperature (TP), with a batch of said components (10) to be treated;
- performing said treatment on said rack (1) loaded with said batch;
- unloading said treated components (10) from said rack (1),
and **characterized in that** the loading and unloading of said rack (1) are performed by an automated manipulator at said preparation temperature (TP), which is an ambient temperature lower than said temperature of end of a martensitic transformation (Mf).

2. Method according to claim 1, **characterized in that** the method includes the successive steps consisting of:
- equipping said rack (1) with a plurality of grippers (2), all made of the same shape memory alloy, and each arranged to return to a reference shape through heating above an temperature of end of a austenitic transformation (Af) specific to said shape memory alloy, which is higher than said temperature of end of a martensitic transformation (Mf);
- bringing said rack (1) equipped with said grippers (2) to a temperature higher than said temperature of end of a austenitic transformation (Af);
- once all said grippers have returned to their said reference shape, bringing said rack (1) equipped with said grippers (2) to said preparation temperature (TP);
- loading said rack (1), at a loading station at said preparation temperature (TP), with a batch of said components (10) to be treated;
- performing said treatment on said rack (1) loaded with said batch;
- after completion of said treatment, returning said rack (1) loaded with said batch to a temperature higher than said temperature of end of a austenitic transformation (Af);
- then returning said rack (1) loaded with said batch to said preparation temperature (TP);
- unloading said treated components (10) from said rack (1).

3. Method according to claim 1 or 2, **characterized in that** the method also includes the steps consisting of:
- after completion of said treatment, returning said rack (1) loaded with said batch to a temperature higher than said temperature of end of a martensitic transformation (Mf);
- then returning said rack (1) loaded with said batch to said preparation temperature (TP).

4. Method according to one of claims 1 to 3, **characterized in that**, when said rack (1) is loaded with said batch of said components (10) to be treated, position determining means are arranged to identify the position of each said distal end (4) of each said gripper (2) to guide thereto a said component (10) loaded by a manipulator means.

5. Method according to claim 4, **characterized in that** at least one said gripper (2) comprises a said first strand (3) which is open at said preparation temperature (TP), and is arranged to be closed on itself in a loop closing around a said component (10), during a mechanical deformation that is applied thereto, and/or at least one said gripper (2) comprises, opposite said distal end (4) thereof, a second strand (5) arranged to form with said first strand (3) a loop closing around a said component (10) during a mechanical deformation that is applied thereto.

6. Method according to claim 4 or 5, **characterized in that** said rack (1) is equipped with at least one means of closure (6) facing at least one said distal end (4) and arranged to form with at least a said first strand (3) a closed loop when said treatment is performed on said rack (1) loaded with said batch.

7. Method according to claim 6, **characterized in that** at least one said means of closure (6) is made of the same shape memory alloy as said grippers (2).

8. Method according to one of claims 1 to 7, **characterized in that** said treatment is an electrolytic or electroplating or electroforming or vapour phase deposition type treatment, and **in that** each said gripper (2) is an electrical conductor electrically connected to said rack (1).

9. Method according to one of claims 1 to 8, **characterized in that** said treatment is performed at a treatment temperature (TT), which is higher than the value of the temperature of end of a martensitic transformation (Mf) specific to said shape memory alloy, but lower than said temperature of end of a austenitic transformation (Af).

10. Method according to one of claims 1 to 9, **characterized in that** said method is implemented for the treatment of timepiece or jewellery components.

11. Rack (1) for the treatment of timepiece components (10), said rack (1) comprising a plurality of grippers (2) adapted to the geometry and to the treatment of said components (10), **characterized in that** each said gripper (2) is made of the same shape memory alloy, and arranged to return to a reference shape through heating above a temperature of end of a martensitic transformation (Mf) specific to said shape memory alloy, and **in that** each said gripper (2) comprises a first strand (3) with at least one distal end (4) arranged for the attachment of a said component (10), and **in that**, either said first strand (3) of at least one said gripper (2) is in the open position at a preparation temperature (TP) and is arranged to be closed on itself in a loop closing around a said component (10) during a mechanical deformation that is applied thereto, or at least one said gripper (2) comprises, opposite said distal end (4), a second strand (5) arranged to form with said first strand (3) a loop closing around a said component (10), during a mechanical deformation that is applied thereto, or said rack (1) comprises at least one means of closure (6) facing at least one said distal end (4) and which is arranged to form with at least a said first strand (3) a closed loop, said at least one said means of closure (6) being made of the same shape memory alloy as said grippers (2), and **characterized in that** at least one said gripper (2) is removable, and **in that** at least one said gripper (2) comprises at least one spring portion (7), arranged to cooperate with elastic retention on a support element (8) comprised in said rack (1).
